# EUROPEAN PATENT APPLICATION

(11) **EP 0 554 962 A1**
(43) Date of publication of application: **11.08.1993**
(21) Application number: 93200305.6
(22) Date of filing: 05.02.1993
(51) Int. Cl.: H03G 9/02, H03G 5/18

(54) **Tone control circuitry having a frequency characteristic dependent on the input signal level**

(30) Priority: 07.02.1992 NL 9200237
(71) Applicant: NOVANEX AUTOMATION N.V., NL-6603 BN Wychen (NL)
(72) Inventor: Laupman, Robert Ronald, NL-6603 BZ Wychen (NL)
(74) Representative: Smulders, Theodorus A.H.J., Ir.

(57) **Abstract**

Level-controlled tone control circuit intended to be connected between a preamplifier on the one hand and a final amplifier on the other of an audio amplifier circuit, this tone control circuit comprising a control amplifier (2) and a tone control amplifier (3), the control amplifier (2) being designed to set the tone control amplifier (3), depending on the input signal level applied, such that the characteristic of the tone control is continuously adjusted to the isophones of the human ear, whilst a part of the required correction characteristic that is approximately repetitive for different sound pressures is included in the amplifier circuit as a fixed correction (4), so that the remaining required correction characteristics of the tone control can be of a simpler order. With the tone control, a surprisingly good dynamic adjustment of the reproduction characteristic to the varying loudness of a reproduced piece of music is obtained.

## Description

This invention relates to a tone control circuit intended to be included between the preamplifier and the final amplifier of an audio amplifier circuit, and comprising a control amplifier and an electronically controllable tone control amplifier, the control amplifier being designed to control the frequency characteristic of the tone control amplifier depending on the input signal level applied.

It is known that in order to obtain an equal loudness impression on the human ear, the sound pressure as a function of the frequency must vary strongly at different listening levels. The so-called isophones indicate that at very low listening levels, with regard to a given sound pressure at approximately 3 kHz, the low frequencies around 20 Hz must be reproduced louder by about 30 dB, and also frequencies around 15 kHz must be reproduced louder by more than 10 dB.

At higher sound pressure levels, the need for such large differences decreases rapidly, amounting to only a few decibels at sound pressures of 90 dB and above. For a discussion of the properties of the human ear at different sound pressure levels, reference can be made to the article "Loudness Compensation: Use and Abuse" by T. Holman and F. Kampmann in Journal of the Audio Engineering Society, Volume 26, no. 7/8, pp. 526-536.

This means that upon variation of the sound volume, the adjustment of the characteristic of the tone control should occur in conformity with the above physiological laws. This can only be realized if it is desired that a piece of music of substantially constant sound intensity be reproduced at a different level in its entirety, but not if a given piece of music contains passages of greatly varying volume. In such cases, an average setting is to be chosen, which cannot be satisfactory for the whole piece.

One might think that in the case of recorded music it can already be fixed in the recording with what characteristic the parts of different loudness are to be recorded. This has proved impossible, however, since it is not known at what average level the music will be played by the user later on: if played loud, the entire characteristic may be "flatter" on average, and if played at a lower level, the characteristic should be "more concave". Accordingly, a proper setting is possible only when the desired level of reproduction has been determined.

EP-A-0122663 discloses a tone control circuit of the above-mentioned type, in which the frequency response of the control signal for a loudspeaker is dynamically controlled depending on the level of reproduction. This loudspeaker is intended for use in a car and the main objective of the tone control is to take into account the maximum cone excursion of the loudspeaker that is permissible for an acceptable distortion of the sound at the high levels of reproduction often called for in cars because of the ambient noise. In addition, it is also mentioned that the dynamic control makes it possible to take into account the specific properties of the human ear.

With the known tone control circuit, however, it is impossible to realize the above-mentioned correction of + 30 dB at low frequencies and + 10 dB at high frequencies, nor is it possible to realize a compensation of the rather complex forms of the isophones of the human ear, requiring not just an amplification of the lowest and highest frequencies.

The object of the present invention is to provide a tone control circuit which makes it possible for the reproduced sound pressure level to be adjusted to the isophones of the human ear at different reproduction levels much more accurately than is possible with the known circuit and, more particularly, a tone control circuit which, notwithstanding the optimum dynamic tone control obtained, is inexpensive to manufacture in that an integrated tone control circuit is employed that is commercially available at a low price.

To that end, the invention provides a tone control circuit of the above-mentioned type, characterized in that in the tone control circuit a circuit having a fixed frequency correction characteristic is included between, on the one hand, the point where the input signal for the control amplifier is derived and, on the other hand, the input of the tone control amplifier, the arrangement being such that the frequency characteristic at the output of the tone control circuit for different input signal levels resembles the isophones of the human ear at different sound pressures.

According to a preferred embodiment, the circuit having a fixed frequency correction characteristic and the tone control amplifier have different crossover points and the filter circuit is designed to attenuate tones in the middle range.

The invention is based on the insight that analogous filters capable of amplifying low frequencies by 30 dB are hard to realize in view of the instability problems arising, but that combining a simple electronically controllable tone control amplifier having a limited control range for both high and low frequencies with a filter having a fixed frequency characteristic does make it possible, with an appropriate choice of the frequency characteristic of the tone control amplifier at high and low input signal levels as well as with an appropriate choice of the frequency characteristic of the fixed filter circuit, to realize such an amplification of the low frequencies in a simple and inexpensive manner, whilst moreover a very good approximation of the isophones of the human ear at different sound pressures is possible. At first sight, this solution is illogical and unobvious to a person of ordinary skill in the art, because it is uncommon, once an amplification of certain frequencies has been obtained, in this case by means of the fixed filter circuit, to partly or wholly undo such amplication, in this case by means of the controllable tone control.

The tone control for the tone control circuit according to the present invention can therefore be a simple, voltage-controlled tone control, as frequently used at present in televisions and the like. Such a voltage-controlled tone control circuit is described in the article "DC-controlled volume and tone control ICs" by W. Eckert in Electronic Components and Applications, vol 5, no. 1, November 1982, pp. 7-13.

The invention is further based on the insight that, because the isophones of the human ear for certain frequency ranges are highly uniform at different sound pressures but have a complex course, it is possible that a part of the required correction characteristic that is approximately repetitive for different sound pressures is included in the amplifier circuit in the form of a fixed frequency correction, *inter alia* by choosing the crossover points and the zero level of, respectively, the tone control circuit and the fixed frequency correction circuit to be different.

The invention will be explained hereinafter on the basis of some exemplary embodiments with reference to the accompanying drawings, in which:
Fig. 1 is a block diagram of a tone control circuit according to the general principle of the invention;
Fig. 2 is a block diagram of the preferred embodiment of the invention;
Fig. 3 is an electronic diagram of a practical implementation of the device according to Fig. 2; and
Figs 4.1 and 4.2 show a number of frequency characteristics such as they are realized in the circuit according to Fig. 3.

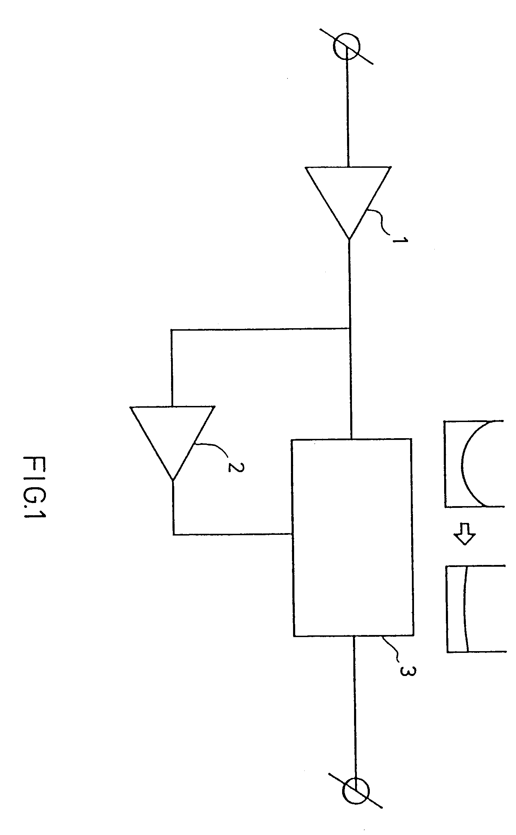

According to the invention, in an audio amplifier circuit the tone control circuit according to Fig. 1 is connected between the tone control and the power amplifier. A preamplifier 1 buffers the incoming signal and feeds it to a control amplifier 2. The preamplifier 1 moreover applies the signal to a tone control amplifier 3, capable of amplifying both low and high frequencies, so that a concave characteristic is obtained. This tone control amplifier is controlled by the control amplifier in such a manner that, at the lowest audible listening level, approximately 30 dB more amplification is obtained at 20 Hz than at 3 kHz and an additional amplification is also obtained at 15 kHz, viz. of approximately 12 dB. Thus, according to the known isophones for low sound pressure levels, the reproduction characteristic of the amplifier is adjusted to the need of the human ear. However, if the sound pressure level increases, the control amplifier 2 will control the tone control amplifier 3 in such a manner that it reduces the amplification of low and high tones so that, at a listening level exceeding 90 dB, a characteristic of the tone control amplifier is produced that is practically "straight" within a few decibels. As is known from the isophones for different levels, the adjustment of the correction of the amplification of low and high tones should already occur at a relatively low sound pressure level because at such a level "exaggerated" high and low corrections already come across as unnatural.

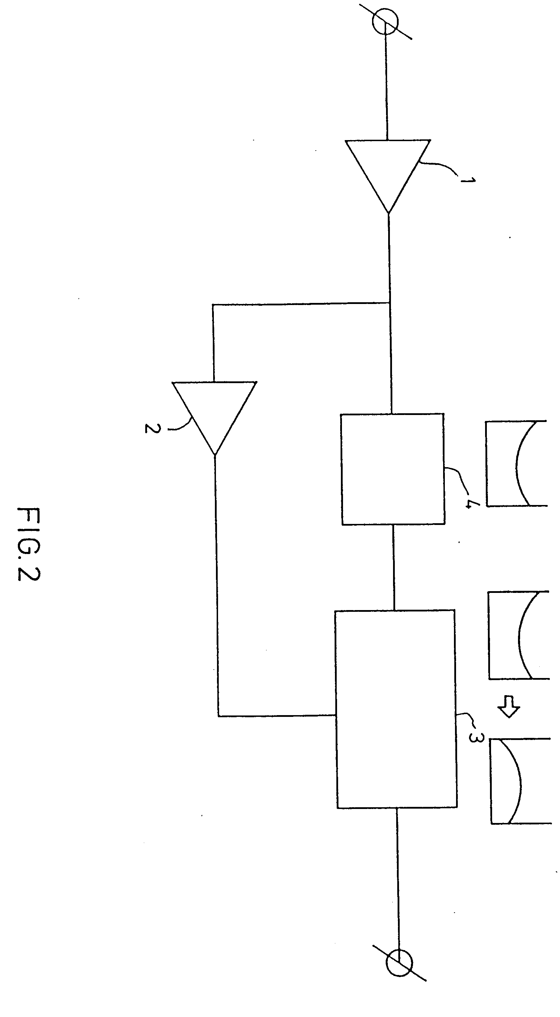

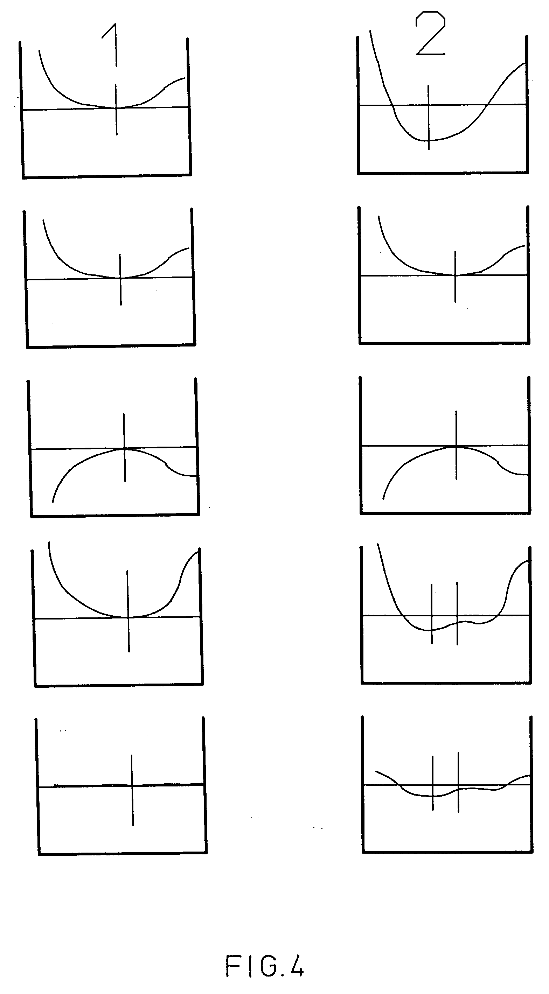

Digitally, in a tone control, a simple low-up amplification of about 30 dB can be realized, whilst a high-up amplification of up to 12 dB is effected. However, the present invention offers a practical solution for the analog realization of the same control range with simple means, as is shown in the exemplary embodiment according to Fig. 2. In Fig. 2, the preamplifier 1 is connected again with the control amplifier 2, which controls a tone control amplifier 3 of the type that is frequently used for the tone control in television sets, for instance. The attraction thereof is that all parameters can be controlled by means of a voltage. This integrated circuit amplifies and attenuates both low and high tones, by an order of magnitude of + and - 15 dB. Accordingly, the amplification is only half of the desired 30-dB amplification that is necessary for optimum adjustment of the reproduction of low tones at low sound pressure levels. Now, by connecting the preamplifier 1 with the filter circuit 4, which amplifies low frequencies by approximately 15 dB and high frequencies by approximately 6 dB, and by coupling this circuit with the tone control amplifier 3 via the control amplifier 2 and setting the tone control amplifier 3 at an amplification at the lowest sound pressure levels of, for instance, 15 dB for low frequencies and approximately 10 dB for high frequencies, at the lowest sound pressure levels a total amplification of +30 dB for low frequencies and +16 dB for high frequencies is obtained, as is desired. If the control amplifier 2 is set in such a manner that upon an increase of the input signal by 90 dB, the characteristic of the tone control amplifier 3 is completely opposite, i.e., a 15-dB attenuation of low frequencies and a 10-dB attenuation of high frequencies, then this characteristic substantially compensates that of the pre-connected filter 4, yielding a substantially straight characteristic with only a minor amplification of the high tones, as is desired. In this way, too, the objective contemplated is realized, while in a simple manner use is made of current integrated building blocks having correction curves of lower order, for instance simple "concave" and "convex" correction curves, which are simple to realize. The foregoing is visualized in Fig. 4.1, where the top graph A shows the frequency response of the fixed filter 4 and the graphs B and C show the frequency response of the tone control amplifier 3 when driven to maximum and minimum power, respectively. The graph A + B shows the frequency response at a very low input signal level and the graph A + C shows the frequency response at the highest input signal level.

Fig. 4.2 shows in what way an even better approximation of the dynamic isophones of the human ear can be obtained. It is observed here that these dynamic isophones, as experiments have shown, do not entirely correspond to the static isophones such as they are shown in the well-known Fletcher-Munson curves. Fig. 4.2 shows in principle the same graphs as Fig. 4.1, but now the crossover point of the fixed filter circuit is different from that of the tone control circuit. The crossover point of the fixed circuit lies, for instance, at 450 Hz and that of the tone control circuit at 1 kHz. In addition, now the amplification of high tones by the fixed filter is 15-18 dB and the amplification and attenuation of high tones by the tone control amplifier is approximately 10 dB. The amplification of low tones by the filter is approximately 15-18 dB and the amplification and attenuation of low tones by the tone control amplifier is approximately 15 dB again. Characteristic is that the fixed filter, as illustrated in graph A, attenuates the middle frequencies by approximately 10 dB. All this results in the characteristic A + B for low signal levels and A + C for high signal levels, which characteristics have been found to be very suitable to obtain in subjects an equal loudness impression at different sound levels throughout the frequency range. It is self-evident that different isophones can be realized by further experiments with different crossover points, different amplification and attenuation factors and differently curved characteristics. Accordingly, the embodiments shown in the drawings and the values as specified only serve to illustrate the possibilities that can be realized with the invention.

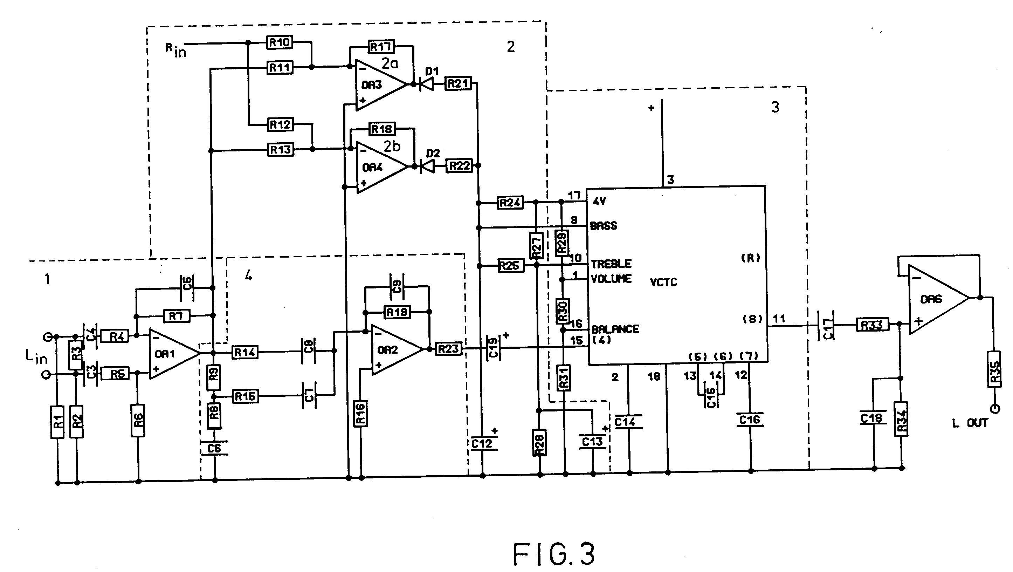

With capacitors, the quickness of reaction of the system can be adjusted to the different needs. The starting point according to the invention is the speed of adjustment of the human ear itself, which is much slower than is supposed, and therefore adjustment by the tone control amplifier according to the invention need not, as a rule, be quick either. An exception is formed by extreme cases where it is desired for sudden loud sound explosions to be taken up quickly. According to the invention, a solution may then be offered by capacitors providing a small delay in the control of the amplification of the low tones and a large delay in the control of the amplification of the high tones. To that end, the control amplifier 2 can be designed in the form of two parallel amplifier branches, one branch controlling the control for the low frequencies and being relatively fast, whilst the other branch controls the control for the high frequencies and is relatively slow. Fig. 3 shows such a design, in which the control amplifier 2 consists of two parallel amplifiers 2a and 2b, and the size of the capacitor C12 in fact determines the control speed for low frequencies and the size of the capacitor C13 determines the control speed for high frequencies. In addition, it is self-evident that the values of the resistors that determine a time constant together with these capacitors also have an influence.

Fig. 3 only shows the left channel of a tone control according to the invention. However, because in this design the voltage-controlled tone control amplifier 3 can take care of the tone control for two channels L and R, both the signal of the right channel and the signal of the left channel are applied to the control amplifier 2, consisting of two parallel branches 2a and 2b, for it to derive from these signals together a control signal for the control of the two channels of the tone control amplifier 3 via the single control input thereof.

For the sake of clarity, in Fig. 3 the corresponding parts of the tone control amplifier shown in Fig. 2 are indicated by means of broken-lined frames with corresponding reference numerals. A discussion of all the separate components shown in Fig. 3 is dispensed with, because the structure of the various amplifier sections is conventional and will immediately be clear to a person of ordinary skill in the art. The tone control IC used in the tone control amplifier 3 may for instance be an IC of the type designated TDA 1524A, the settings of which can be readily found in the various handbooks on ICs. Hereinbelow, however, it will be indicated briefly which components in the diagram shown in Fig. 3 are determinative of the frequency characteristic of the tone control circuit according to the invention.

In the filter circuit 4, which is active and is built up around an operational amplifier OA2, the combination of the resistor R14 and the capacitor C8 determines the degree of high-frequency amplification and the combination of the resistor R9 and the capacitor C6 as well as the combination of the resistor R15 and the capacitor C7 determine the low-frequency amplification. The resistor R8 determines the attenuation of frequencies in the middle range, which attenuation, as indicated hereinabove, is desirable in order to maintain the desired "dip" in the isophones for frequencies in the middle range for all sound pressure levels. The amplification/attenuation behaviour of the tone control amplifier 3 is in principle determined by the capacitor C16 for low frequencies and by the capacitor C15 for high frequencies. The variation of the values of the resistors R24, R25, R27 and R28, however, also has some influence on the course of the control of the amplification and attenuation for low and high frequencies.

For the practical application of the device according to the invention, it will be necessary to adapt the final amplifier connected so as to realize the correct sound level in the listening space. If one determines the desired loudness and hence the required amplifier power for the lowest level, the adaptation of the final amplifiers must be such as to also realize the above-stated 90 dB when the system has traversed its control characteristic and presents a substantially straight amplification.

The result of the measures according to the invention is an astounding detailedness of the sounds at low and very low levels, which provides exceptional listening pleasure.

It is obvious to integrate the amplifiers 1 and 2, optionally with the filter 4 of Fig. 2. In the end, this results in two ICs accommodating the entire provision, preferably in stereo.

If, in the case of carefully set-up and professional applications, it is assumed that the power of the final amplifier is adjusted to the acoustic needs of the listening space, it is recommended, in accordance with the invention, that the device described be built together with the final amplifier or be added thereto as a preamplifier.

According to the invention, this addition is equally effective even in the most modern designs of loudspeaker boxes with built-in final amplifiers. If the boxes are driven to full power, they give the same reproduction characteristic as was originally the case, but at lower sound pressure levels the device according to the invention will automatically adjust the amplification characteristic to the need of the human ear, regardless of whether the volume is manually varied with the preamplifier or whether pieces of music are reproduced which contain passages of different sound levels in the music itself.

In the professional sector, the device according to the invention has many possibilities of application. If an installation for background music is played at a low level and suddenly a person must be called up, the characteristic of the amplifier is automatically adjusted. If an orchestra desires to alternate romantic numbers and louder, cheerful music, a device according to the invention can always provide for the correct adjustment to the listening hall by connecting it between the mixer and the final amplifiers.

## Claims

1. A tone control circuit intended to be included between the preamplifier and the final amplifier of an audio amplifier circuit, and comprising a control amplifier and an electronically controllable tone control amplifier, the control amplifier being designed to control the frequency characteristic of the tone control amplifier depending on the input signal level applied, characterized in that in the tone control circuit a circuit having a fixed frequency correction characteristic is included between, on the one hand, the point where the input signal for the control amplifier is derived and, on the other hand, the input of the tone control amplifier, the arrangement being such that the frequency characteristic at the output of the tone control circuit for different input signal levels resembles the isophones of the human ear at different sound pressures.

2. A tone control circuit as claimed in claim 1, characterized in that the tone control amplifier is capable of amplifying and attenuating low frequencies by at least approximately 15 dB and is capable of amplifying and attenuating high frequencies by at least approximately 10 dB and that the filter circuit is designed to amplify low frequencies by at least approximately 15 dB and high frequencies by at least approximately 15 dB, the control amplifier controlling the tone control amplifier so that, at low input signal levels, the amplification of high and low tones by the tone control amplifier and the amplification of high and low tones by the filter circuit supplement each other, whilst at higher input signal levels the attenuation of high and low frequencies by the tone control amplifier is set such that, at the highest signal levels, the frequency characteristic of the filter circuit is substantially compensated.

3. A tone control circuit as claimed in claim 1 or 2, characterized in that the tone control amplifier and the filter circuit have different crossover points and that the filter circuit is designed to attenuate tones in the middle range.

4. A tone control circuit as claimed in claim 1, 2, or 3, characterized in that the control speed of the tone control for low frequencies differs from that for high frequencies.

5. A tone control circuit as claimed in claim 4, characterized in that the control speed of the tone control for low frequencies is higher than that for high frequencies in that in the coupling between the control amplifier and the tone control amplifier a damping capacitor (C12) for low frequencies has been chosen to be smaller than a damping capacitor (C13) for high frequencies.

6. A tone control circuit as claimed in at least one of claims 1-5, characterized in that the tone control has been built together with the final amplifier.

7. A tone control as claimed in at least one of claims 1-5, characterized in that, for each audio channel, it has been built together with the final amplifier and the loudspeaker or loudspeakers.
